(19) Europäisches Patentamt
European Patent Office
Office européen des brevets

(11) **EP 2 582 072 A1**

(12) **EUROPEAN PATENT APPLICATION**
published in accordance with Art. 153(4) EPC

(43) Date of publication:
**17.04.2013 Bulletin 2013/16**

(51) Int Cl.:
**H04J 11/00** *(2006.01)*  **H04L 27/01** *(2006.01)*

(21) Application number: **11792425.8**

(22) Date of filing: **06.06.2011**

(86) International application number:
**PCT/JP2011/062984**

(87) International publication number:
**WO 2011/155468 (15.12.2011 Gazette 2011/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.06.2010 JP 2010132376**

(71) Applicant: **NTT DoCoMo, Inc.**
**Tokyo 100-6150 (JP)**

(72) Inventor: **HIGUCHI, Kenichi**
**Tokyo 100-6150 (JP)**

(74) Representative: **HOFFMANN EITLE**
**Patent- und Rechtsanwälte**
**Arabellastrasse 4**
**81925 München (DE)**

(54) **MOBILE TERMINAL DEVICE, WIRELESS BASE STATION DEVICE AND WIRELESS COMMUNICATION METHOD**

(57)    To provide a mobile terminal apparatus, radio base station apparatus and radio communication method for enabling to control a coding rate with increasing coding gain in the case of adopting a turbo code in DFT spreading OFDM, according to the invention, a mobile terminal apparatus performs turbo coding on transmission data, performs discrete Fourier transform on the signal subjected to turbo coding, performs frequency-domain puncture processing on the signal subjected to discrete Fourier transform, maps the signal subjected to the frequency-domain puncture processing to a subcarrier, and transmits the signal to a radio base station apparatus by SC-FDMA.

FIG. 4

EP 2 582 072 A1

**Description**

Technical Field

The present invention relates to a mobile terminal apparatus, radio base station apparatus and radio communication method in the next-generation mobile communication system.

Background Art

In recent years, various kinds of frequency-domain signal processing have been proposed to improve transmission characteristics of single-carrier transmission. For example, Discrete Fourier Transform (DFT) spreading Orthogonal Frequency Division Multiplexing (OFDM) (Non-patent Documents 1 to 3) for generating single-carrier transmission signals in the frequency domain enables flexible control of the transmission frequency and the frequency bandwidth, and facilitates actualization of dynamic scheduling corresponding to the channel state. Further, in DFT spreading OFDM, since a Cyclic Prefix (CP) is applied as in an OFDM signal, it is possible to actualize channel equalization of low operation amounts in the frequency domain (Non-patent Document 4), and it is possible to improve reception quality in a frequency selective fading channel. Further, Non-patent Document 5 proposes dynamic spectrum control in the frequency domain in single-carrier transmission. In dynamic spectrum access, based on the DFT spreading OFDM, a frequency-domain transmission signal of DFT output is mapped to contiguous/non-contiguous frequencies having good channel states.

Meanwhile, turbo codes (Non-patent Document 6) have strong error correcting capabilities, and therefore, in recent years, have been adopted in channel coding schemes of various radio communication systems. Obviously, as the channel coding rate is decreased, higher coding gain is obtained. However, at this point, spectral efficiency decreases at the same time. Therefore, in a radio communication system as described in Non-patent Document 3, a configuration of a turbo coder is not changed (with the original coding rate kept constant), and in increasing the channel coding rate to improve spectral efficiency, time-domain puncturing is used to thin out some (mainly parity bits) of coded bits of a turbo coder output (Non-patent Document 7).

Prior Art Literature

Non-patent Literature

[Non-patent Document 1] D. Garda and H. Rohling, "A low complexity transmitter structure for OFDM-FDMA uplink system," in Proc. IEEE VTC2000-Spring, May 2002.
[Non-patent Document 2] R. Dinis, D. Falconer, C.T. Lam, and M. Sabbaghian, "A multiple access scheme for the uplink of broadband wireless access," in Proc. IEEE Globecom2004, Dec. 2004.
[Non-patent Document 3] 3GPP TS36.300, Evolved Universal Terrestrial Radio Access (E-UTRA) and Evolved Universal Terrestrial Radio Access Network (E-UTRAN); Overall description.
[Non-patent Document 4] D. Falconer, S.L. Ariyavisitakul, A. Benyamin-Seeyar, and B. Edison, "frequency domain equalization for single-carrier broadband wireless systems," IEEE Commun. Mag., vol. 40, no. 4, pp. 58-66, April 2002.
[Non-patent Document 5] S. Sampei and S. Ibi, "flexible spectrum control and receiver performance improvement technologies for B3G wireless system," in Proc. IEEE PIMRC'06, Sept. 2006.
[Non-patent Document 6] C. Berrou, A. Glavieux, and P. Thitimajshima, "Near Shannon limit error-correcting coding and decoding: turbo-codes," in Proc. IEEE ICC' 93, May 1993.
[Non-patent Document 7] D. N. Rowitch, and L. B. Milstein, "On the performance of hybrid FEC/ARQ systems using rate compatible punctured turbo (RCPT) codes," IEEE Trans. Commun., vol. 48, no. 6, pp. 948-959, June 2000.

Summary of Invention

Technical Problem

However, when above-mentioned time-domain puncturing is performed, parity bits are punctured, and there is a problem that coding gain decreases.

The present invention was made in view of the respect, and it is an object of the invention to provide a mobile terminal apparatus, radio base station apparatus and radio communication method for enabling to control a coding rate with increasing coding gain in the case of adopting a turbo code in DFT spreading OFDM.

Solution to the Problem

A mobile terminal apparatus of the invention is a mobile terminal apparatus for transmitting a signal to a radio base station apparatus by SC-FDMA, and is characterized by having a turbo coding section configured to perform turbo coding on transmission data, a discrete Fourier transform section configured to perform discrete Fourier transform on a signal subjected to turbo coding, a first puncture section configured to perform frequency-domain puncture processing on the signal subjected to discrete Fourier transform, and a subcarrier mapping section configured to map the signal subjected to the frequency-domain puncture processing to a subcarrier.

A radio base station apparatus of the invention is characterized by having a subcarrier demapping section configured to demap a reception signal from a subcarrier, a first depuncture section configured to perform frequency depuncture processing on the signal subjected to subcarrier demapping, an inverse discrete Fourier transform section configured to perf orm inverse discrete Fourier transform on the signal subjected to the frequency depuncture processing, and a turbo decoding section configured to perform turbo decoding on the signal subjected to inverse discrete Fourier transform to obtain reception data.

A radio communication method of the invention is a radio communication method for transmitting a signal from a mobile terminal apparatus to a radio base station apparatus by SC-FDMA, and is characterized by having in the mobile terminal apparatus the step of performing turbo coding on transmission data, the step of performing discrete Fourier transform on a signal subjected to turbo coding, the first puncture step of performing frequency-domain puncture processing on the signal subjected to discrete Fourier transform, and the step of mapping the signal subjected to the frequency-domain puncture processing to a subcarrier, and in the radio base station apparatus, the step of demapping a reception signal from a subcarrier, the first depuncture step of performing frequency depuncture processing on the signal subjected to subcarrier demapping, the step of performing inverse discrete Fourier transform on the signal subjected to the frequency depuncture processing, and the step of performing turbo decoding on the signal subjected to inverse discrete Fourier transform to obtain reception data.

Technical Advantages of the Invention

According to the invention, the mobile terminal apparatus performs turbo coding on transmission data, performs discrete Fourier transform on the signal subjected to turbo coding, performs frequency-domain puncture processing on the signal subjected to discrete Fourier transform, maps the signal subjected to the frequency-domain puncture processing to a subcarrier, and transmits the signal to a radio base station apparatus by SC-FDMA, and therefore, in the case of adopting a turbo code in DFT spreading OFDM, it is possible to control the coding rate with increasing coding gain.

Brief Description of Drawings

FIG. 1 is a diagram to explain time-domain puncture processing in a conventional turbo code:

FIG. 2 is a diagram illustrating a radio communication system for performing a radio communication method of the invention;

FIG. 3 is a block diagram illustrating a schematic configuration of a mobile terminal apparatus according to an Embodiment of the invention;

FIG. 4 is a block diagram to explain processing sections including a baseband processing section of the mobile terminal apparatus as shown in FIG. 3;

FIG. 5 is a block diagram illustrating a schematic configuration of a radio base station apparatus according to the Embodiment of the invention;

FIG. 6 is a block diagram to explain processing sections including a baseband processing section of the base station apparatus of the invention;

FIG. 7 is a diagram to explain frequency-domain puncture processing in a turbo code in the invention;

FIG. 8 is a table to explain the relationship between time-domain puncturing and frequency-domain puncturing;

FIGS. 9A and 9B are graphs illustrating the relationship of Bit Error Rate (BER) with average received signal energy/noise power density ratio ($E_b/N_0$) per information bit;

FIGs. 10A and 10B are graphs illustrating the relationship of Frame Error Rate (FER) with received $E_b/N_0$; and

FIG. 11A and 11B are graphs illustrating the relationship of average FER with average received $E_b/N_o$.

Description of Embodiments

An Embodiment of the invention will specifically be described below with reference to accompanying drawings.

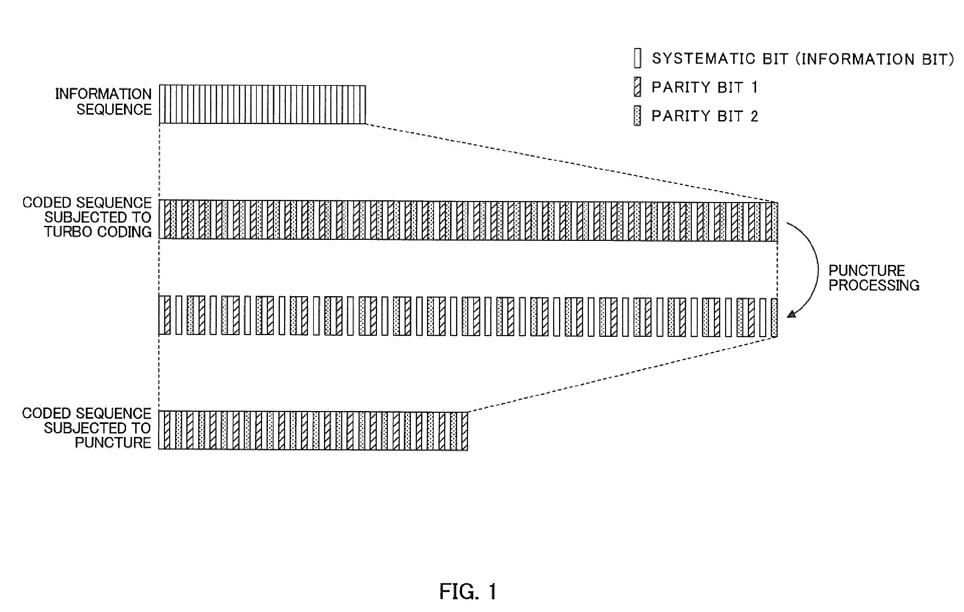

Puncture processing in a turbo code will be described first. The conventional puncture processing in a turbo code is time-domain puncture processing. In other words, an information sequence is turbo-coded, and then, the puncture processing is performed on the coded sequence subjected to turbo coding. First, as shown in FIG. 1, an information sequence (systematic bits (information bits)) is turbo-coded. FIG. 1 shows the case where two coders are used, each of the coders generates parity bits 1 and 2, and the coding rate is thereby 1/3. Then, time-domain puncture processing is performed on the coded sequences subjected to turbo coding. The pattern to puncture is a pattern known between the transmitter and the receiver. By this means, it is possible to control the coding rate to rates higher than 1/3.

In such time-domain puncturing, since all coded sequences cannot be transmitted, coding gain is small. The inventor of the invention noted this respect, found out that it is possible to control the coding rate while minimizing reductions in coding gain by adopting frequency puncturing in a turbo code in DFT spreading OFDM, and arrived at the invention.

In other words, it is the gist of the invention that a mobile terminal apparatus performs turbo coding on transmission data, performs discrete Fourier transform on a signal subjected to turbo coding, performs frequency-domain puncture processing on the signal subjected to discrete Fourier transform, maps the signal subjected to the frequency-domain puncture processing to a subcarrier, transmits the signal to a radio base station apparatus by SC-FDMA, and by this means, in the case of adopting a turbo code in DFT spreading OFDM, controls the coding rate with increasing coding gain.

In this frequency-domain puncturing, in DFT spreading OFDM, discrete Fourier transform (DFT) is performed on coded symbols subjected to turbo coding, and some frequency components (spectrum) are punctured to increase the coding rate. As distinct from conventional time-domain puncturing, frequency-domain puncturing enables all coded bits to be transmitted. Therefore, as compared with time-domain puncturing, it is possible to increase coding gain.

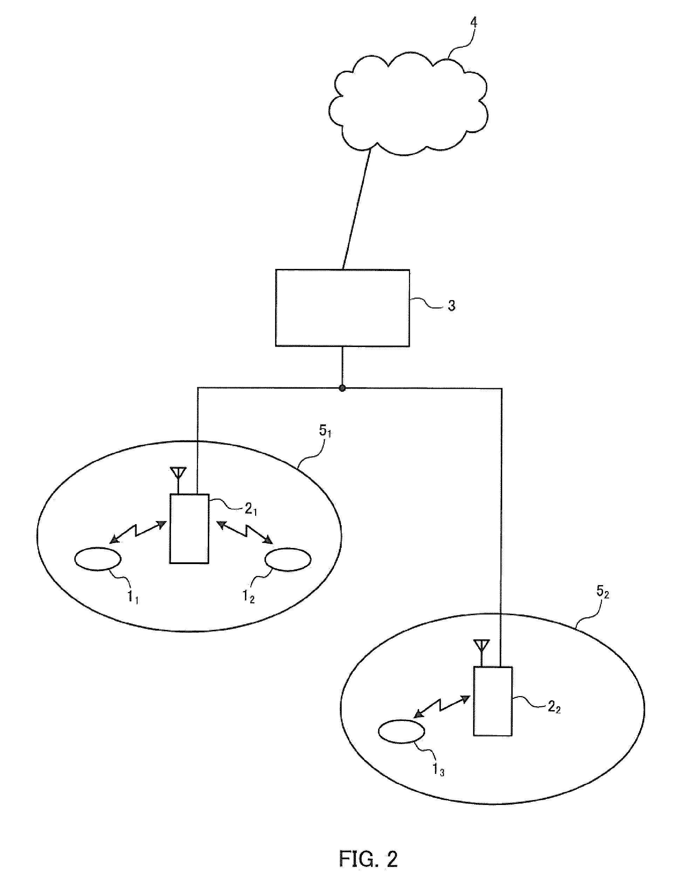

FIG. 2 is a diagram illustrating a radio communication system having mobile terminal apparatuses and radio base station apparatuses according to the Embodiment of the invention.

The radio communication system is a system to which, for example, E-UTRA (Evolved ULTRA and UTRAN) is applied. The radio communication system is provided with radio base station apparatuses (eNB: eNodeB) 2 ($2_1$, $2_2$,..., $2_1$, 1 is an integer where 1>0) and a plurality of mobile terminal apparatuses (UE) $1_n$ ($1_1$, $1_2$, $1_3$,...,$1_n$, n is an integer where n>0) that communicate with the radio base station apparatuses 2. The radio base station apparatuses 2 are connected to an upper station, for example, an access gateway apparatus 3, and the access gateway apparatus 3 is connected to a core network 4 . The mobile terminal apparatus $1_n$ communicates with the radio base station apparatus 2 in a cell 5 ($5_1$, $5_2$) by E-UTRA. This Embodiment shows two cells, but the invention is similarly applicable to three cells or more. In addition, each of the mobile terminal apparatuses ($1_1$, $1_2$, $1_3$,..., $1_n$) has the same configuration, function and state, and is described as a mobile terminal apparatus $1_n$ unless otherwise specified in the following description.

In the radio communication system, as a radio access scheme, OFDM (Orthogonal Frequency Division Multiplexing) is applied in downlink, while SC-FDMA (Single-Carrier Frequency Division Multiple Access) is applied in uplink. OFDM is a multicarrier transmission scheme for dividing a frequency band into a plurality of narrow frequency bands (subcarriers), and mapping data to each subcarrier to perform communications. SC-FDMA is a single-carrier transmission scheme for dividing a frequency band for each terminal so that a plurality of mobile terminal apparatuses uses mutually different frequency bands, and thereby reducing interference among the mobile terminal apparatuses.

Described herein are communication channels in E-UTRA.

In downlink, used are the Physical Downlink Shared Channel (PDSCH) shared among the mobile terminal apparatuses $1_n$, and the Physical Downlink Control Channel (PDCCH). The Physical Downlink Control Channel is also called the downlink L1/L2 control channel. User data i.e. normal data signals are transmitted on the Physical Downlink Shared Channel. Meanwhile, on the Physical Downlink Control Channel are transmitted downlink scheduling information (DL Scheduling Information), acknowledgement/negative acknowledgement information (ACK/NACK), uplink grant (UL Grant), TPC command (Transmission Power Control Command), etc. For example, the downlink scheduling information includes an ID of a user to perform communications using the Physical Downlink Shared Channel, information of a transport format of the user data, i.e. information on the data size, modulation scheme, and retransmission control (HARQ), downlink resource block assignment information, etc.

Meanwhile, for example, the uplink scheduling grant includes an ID of a user to perform communications using the Physical Uplink Shared Channel, information of a transport format of the user data, i.e. information on the data size and modulation scheme, uplink resource block assignment information, information on transmission power of the uplink shared channel, etc. Herein, the uplink resource block corresponds to frequency resources, and is also called the resource unit.

Further, the acknowledgement/negative acknowledgement information (ACK/NACK) is acknowledgement/negative acknowledgement information concerning the shared channel in uplink. The content of acknowledgement/negative acknowledgement information is expressed by Acknowledgement (ACK) indicating that the transmission signal is properly received or Negative Acknowledgement (NACK) indicating that the transmission signal is not properly received.

In uplink, used are the Physical Uplink Shared Channel (PUSCH) shared among the mobile terminal apparatuses

$1_n$, and the Physical Uplink Control Channel (PUCCH). User data i.e. normal data signals are transmitted on the Physical Uplink Shared Channel. Meanwhile, on the Physical Uplink Control Channel is transmitted downlink channel quality information (CQI: Channel Quality Indicator) used in scheduling processing of the physical shared channel in downlink and adaptive modulation/demodulation and coding processing (AMC: Adaptive Modulation and Coding Scheme), and acknowledgement/negative acknowledgement information of the Physical Downlink Shared Channel.

On the Physical Uplink Control Channel, a scheduling request to request resource allocation of the uplink shared channel, release request in persistent scheduling and the like may be transmitted, in addition to the CQI and acknowledgement/negative acknowledgement information. Herein, resource allocation of the uplink shared channel means that a radio base station apparatus notifies a mobile terminal apparatus that the mobile terminal apparatus is allowed to perform communications using an uplink shared channel in a subsequent subframe, using the Physical Downlink Control Channel in some subframe.

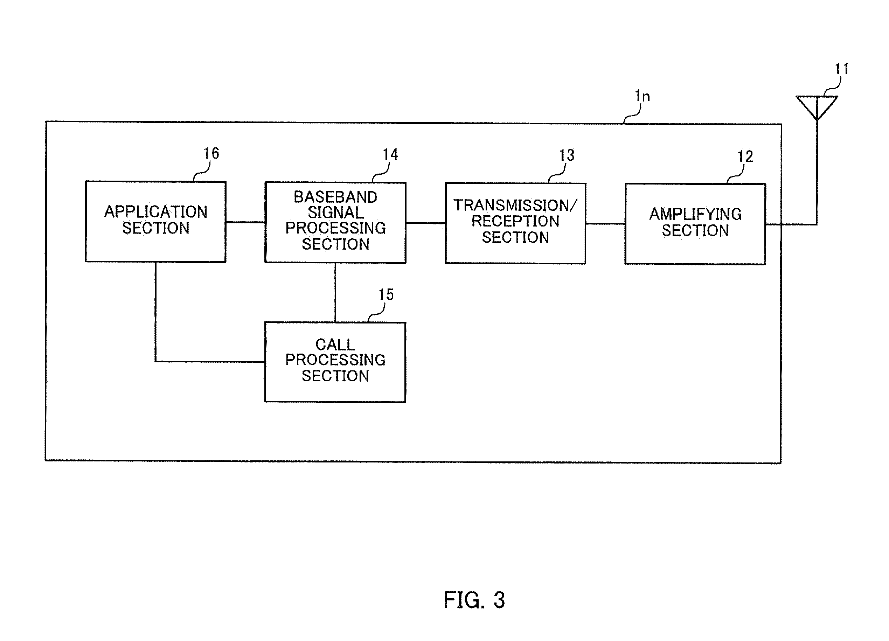

FIG. 3 is a block diagram illustrating a schematic configuration of the mobile terminal apparatus according to the Embodiment of the invention. The mobile terminal apparatus $1_n$ as shown in FIG. 3 is mainly comprised of an antenna 11, amplifying section 12, transmission/reception section 13, baseband signal processing section 14, call processing section 15 and application section 16.

In the mobile terminal apparatus $1_n$ with such a configuration, with respect to a downlink signal, a radio frequency signal received in the antenna 11 is amplified in the amplifying section 12 so that reception power is corrected to certain power under AGC (Auto Gain Control). The amplified radio frequency signal is frequency-converted into a baseband signal in the transmission/reception section 13. The baseband signal is subjected to predetermined processing (error correction, decoding, etc.) in the baseband signal processing section 14, and then, output to the call processing section 15 and application section 16. The call processing section 15 performs management of communications with the radio base station apparatus 2, etc. and the application section 16 performs processing concerning higher layers than the physical layer and MAC layer. The mobile terminal apparatus In of the invention receives at least a downlink signal including a reference signal from each of a plurality of radio base station apparatuses involved in downlink CoMP.

With respect to an uplink signal, the application section 16 inputs the signal to the baseband signal processing section 14. The baseband signal processing section 14 performs retransmission control processing, scheduling, transmission format selection, channel coding and the like on the signal to transfer to the transmission/reception section 13. The transmission/reception section 13 frequency-converts the baseband signal output from the baseband signal processing section 14 into a radio frequency signal. The frequency-converted signal is then amplified in the amplifying section 12 and transmitted from the antenna 11. The mobile terminal apparatus $1_n$ of the invention transmits feedback information including a measurement result of channel quality to each of a plurality of radio base station apparatuses.

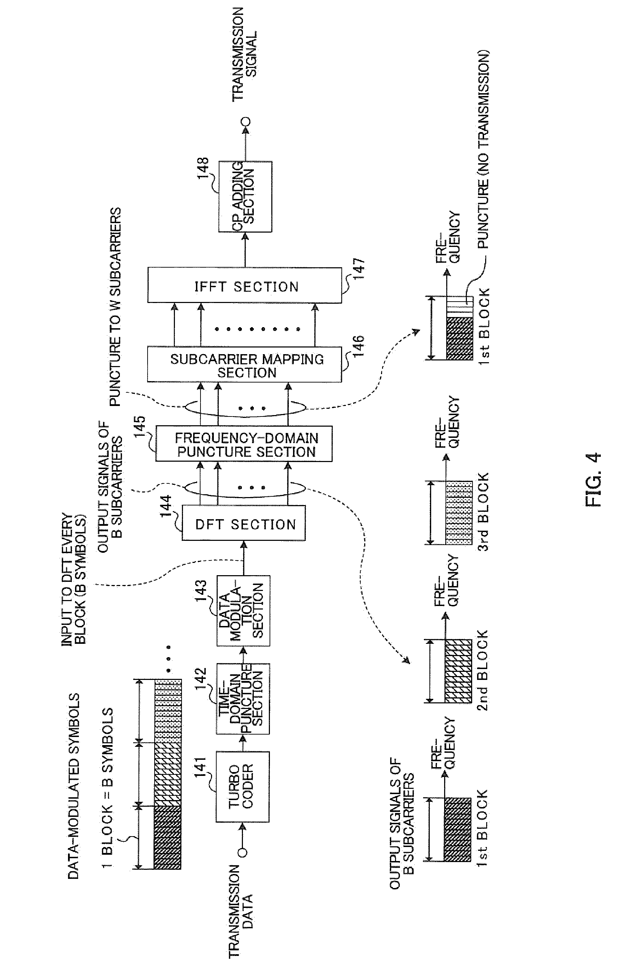

FIG. 4 is a block diagram illustrating a configuration of processing sections including the baseband signal processing section in the mobile terminal apparatus as shown in FIG. 3. The mobile terminal apparatus as shown in FIG. 4 is provided with a transmission section and a reception section, and to simplify the description, FIG. 4 shows only the transmission section. The transmission section is provided with a turbo coder 141, time-domain puncture section 142, data modulation section 143, DFT (Discrete Fourier Transform) section 144, frequency-domain puncture section 145, subcarrier mapping section 146, IFFT (Inverse Fast Fourier Transform) section 147, and CP (Cyclic Prefix) adding section 148.

The turbo coder 141 performs turbo coding on systematic bits that is an information sequence to be a coded sequence. As shown in FIG. 1, the coded sequence includes systematic bits and parity bits. The turbo coder 141 outputs the coded sequence subjected to turbo coding to the time-domain puncture section 142.

As shown in FIG. 1, the time-domain puncture section 142 performs puncture processing on the coded sequence subj ected to turbo coding in the time domain. In the puncture processing, the pattern to puncture is known between the transmission side and the reception side (radio base station apparatus). The time-domain puncture section 142 outputs the puncture-processed coded sequence to the data modulation section 143.

The data modulation section 143 data-modulates the puncture-processed coded sequence with a data modulation scheme corresponding to the MCS (Modulation and Coding Scheme) information. The data modulation section 143 outputs the data-modulated coded sequence to the DFT section 144. The DFT section 144 transforms the data signal in the time domain into signals in the frequency domain. As shown in FIG. 4, the DFT section 144 performs DFT processing on data-modulated symbols (1 block=B symbols) for each block, and outputs signals of B subcarriers. Thus, signals of B symbols are subjected to the DFT processing to be signals of B subcarriers, and orthogonality is thereby maintained. The DFT section 144 outputs the DFT-processed signals to the frequency-domain puncture section 145.

The frequency-domain puncture section 145 punctures the subcarriers subjected to DFT in the frequency domain. For example, as shown in FIG. 4, the frequency-domain puncture section 145 punctures the signals of B subcarriers to W subcarriers (W<B). Data is not transmitted in the punctured subcarrier. In addition, the pattern of subcarriers to puncture is known between the transmission side and the reception side (radio base station apparatus). In FIG. 4, subcarriers on the back side in the block are punctured. The frequency-domain puncture section 145 outputs signals subjected to frequency-domain puncture to the subcarrier mapping section 146. In addition, subcarriers on the front side may be punctured, or puncturing may be made periodically. Further, the puncture pattern may be changed adaptively corresponding to the reception quality. In changing the puncture pattern adaptively, it is necessary to notify of the change.

The subcarrier mapping section 146 maps the signals subjected to frequency-domain puncture to subcarriers based on scheduling information. The subcarrier mapping section 146 outputs the subcarrier-mapped signals to the IFFT section 147. The IFFY section 147 performs IFFT on the subcarrier-mapped signals to transform into a signal in the time domain. The IFFT section 147 outputs the signal subjected to IFFT to the CP adding section 148. The CP adding section 148 adds a CP to the signal subjected to IFFT. A transmission signal is thus generated.

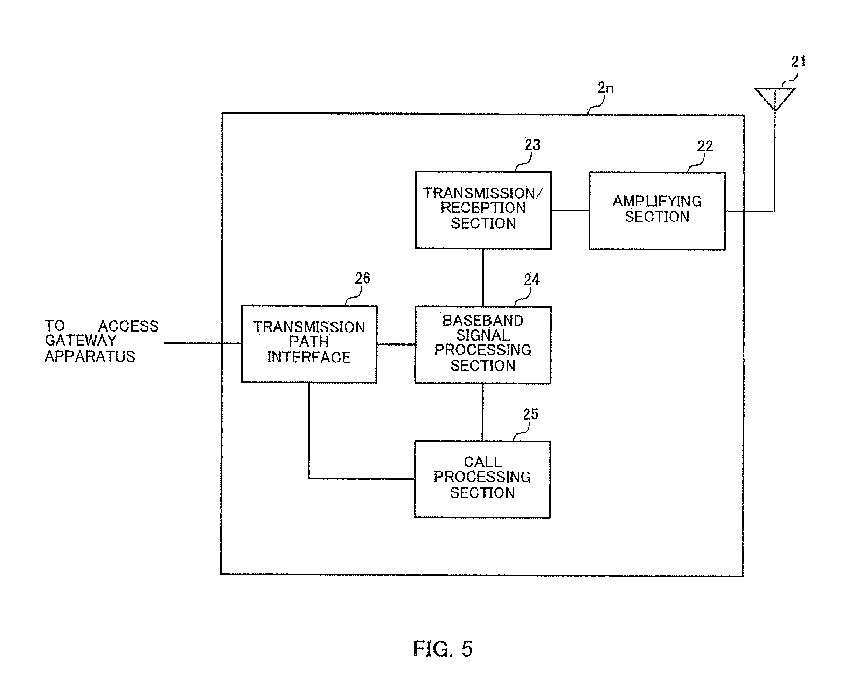

FIG. 5 is a block diagram illustrating a schematic configuration of the radio base station apparatus according to the Embodiment of the invention. The radio base station apparatus $2_n$ as shown in FIG. 5 is mainly comprised of an antenna 21, amplifying section 22, transmission/reception section 23, baseband signal processing section 24, call processing section 25 and transmission path interface 26.

In the radio base station apparatus $2_n$ with such a configuration, with respect to an uplink signal, a radio frequency signal received in the antenna 21 is amplified in the amplifying section 22 so that reception power is corrected to certain power under AGC. The amplified radio frequency signal is frequency-converted into a baseband signal in the transmission/reception section 23. The baseband signal is subjected to predetermined processing (error correction, decoding, etc.) in the baseband signal processing section 24, and then, is transferred to the access gateway apparatus, not shown, via the transmission path interface 26. The access gateway apparatus is connected to the core network, and manages each mobile terminal apparatus. Further, concerning uplink, the reception SINR and interference level of the radio frequency signal received in the radio base station apparatus 2 are measured based on the uplink baseband signal. The call processing section 25 transmits and receives call processing control signals to/from a radio control station that is an upper apparatus, and performs status management of the radio base station apparatus 2 and resource allocation.

With respect to a downlink signal, the upper apparatus inputs the signal to the baseband signal processing section 24 via the transmission path interface 26. The baseband signal processing section 24 performs retransmission control processing, scheduling, transmission format selection, channel coding and the like on the signal to transfer to the transmission/reception section 23. The transmission/reception section 23 frequency-converts the baseband signal output from the baseband signal processing section 24 into a radio frequency signal. The frequency-converted signal is then amplified in the amplifying section 22 and transmitted from the antenna 21.

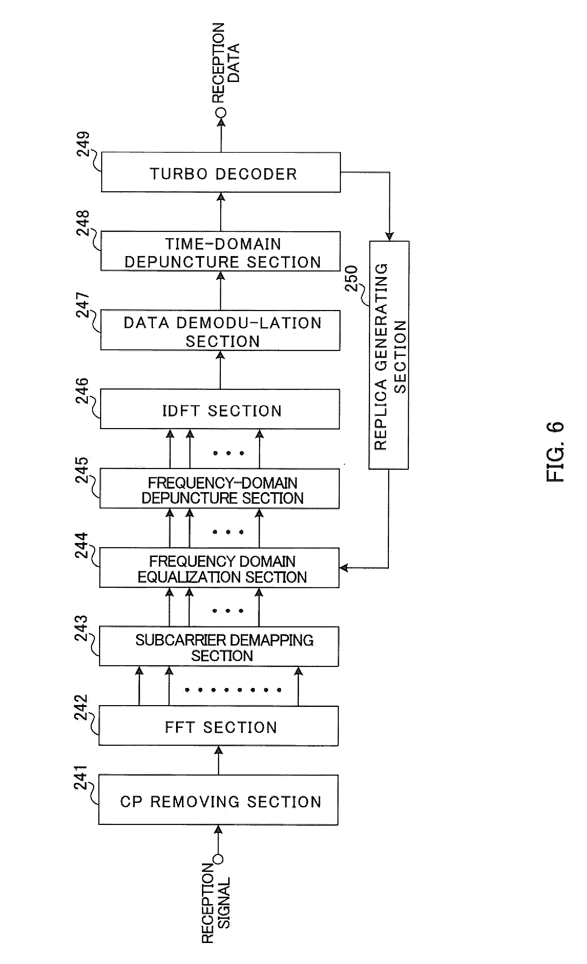

FIG. 6 is a block diagram illustrating a configuration of processing sections including the baseband signal processing section in the radio base station apparatus as shown in FIG. 5. The radio base station apparatus as shown in FIG. 6 is provided with a transmission section and a reception section, and to simplify the description, FIG. 6 shows only the reception section. The reception section is provided with a CP removing section 241, FFT (Fast Fourier Transform) section 242, subcarrier demapping section 243, frequency domain equalization section 244, frequency-domain depuncture section 245, IDFT (Inverse Discrete Fourier Transform) section 246, data demodulation section 247, time-domain depuncture section 248, turbo decoder 249, and replica generating section 250.

The CP removing section 241 removes a CP from a reception signal to extract an effective signal portion. The CP removing section 241 outputs the CP-removed reception signal to the FFT section 242. The FFT section 242 performs FFT on the Cup-removed reception signal to transform into signals in the frequency domain. The FFT section 242 outputs the signals subjected to FFT to the subcarrier demapping section 243. The subcarrier demapping section 243 extracts signals in the frequency domain from the signals subjected to FFT using resource mapping information. The subcarrier demapping section 243 outputs subcarrier-demapped signals to the frequency domain equalization section 244.

The frequency domain equalization section 244 performs equalization of the frequency domain on the subcarrier-demapped signals in the frequency domain. Further, after the first time, the frequency domain equalization section 244 performs frequency-domain turbo equalization processing, described later, using an interference replica generated in the replica generating section 250. The frequency domain equalization section 244 outputs equalized signals to the frequency-domain depuncture section 245.

The frequency-domain depuncture section 245 depunctures the signals equalized in the frequency domain. For example, in the case as shown in FIG. 4, the frequency-domain depuncture section 245 depunctures signals of W subcarriers to signals of B subcarriers. In addition, the pattern of subcarriers to depuncture is known between the transmission side (mobile terminal apparatus) and the reception side. In FIG. 4, subcarriers on the back side in the block are depunctured. The frequency-domain depuncture section 245 outputs the signals subjected to frequency-domain depuncturing to the IDFT section 246. The IDFT section 246 transforms the signals in the frequency domain into a signal in the time domain. The IDFT section 246 outputs the signal subjected to IDFT to the data demodulation section 247.

The data demodulation section 247 data-demodulates the IDFT-processed signal with a data modulation scheme corresponding to a transmission format (coding rate and demodulation scheme). The data demodulation section 247 outputs the data-demodulated signal to the time-domain depuncture section 248. The time-domain depuncture section 248 performs depuncture processing on the data-demodulated signal in the case as shown in FIG. 1. In the depuncture processing, the pattern to depuncture is known between the transmission side (mobile terminal apparatus) and the reception side. Herein, depuncturing is performed with the pattern as shown in FIG. 1. The time-domain depuncture section 248 outputs the depuncture-processed coded sequence to the turbo decoder 249.

The turbo decoder 249 turbo-decodes the depuncture-processed coded sequence to output as reception data. The turbo decoder 249 outputs the turbo-decoded reception data to the replica generating section 250. In addition, after the predetermined number of repetitions, the turbo-decoded reception data is extracted, and reproduction processing of transmission data is completed.

The replica generating section 250 generates a replica of interference occurring by frequency-domain puncture for frequency domain equalization using the reception data, and outputs the interference replica to the frequency domain equalization section 244. The frequency domain equalization section 244 subtracts (cancels) the interference replica from the subcarrier-demapped signal, and performs frequency domain equalization processing on the signal subjected to interference cancellation. The frequency domain equalization processing is SC/MMSE frequency domain turbo equalization processing for performing linear filtering of MMSE (Minimum Mean Squared Error filter) model after soft interference canceller (SC: Soft Canceller) . By performing such SC/MMSE frequency domain turbo equalization processing, it is possible to reduce inter-symbol interference (ISI) occurring in performing the frequency-domain puncture processing on the transmission side.

Described is the case of performing radio communications between the mobile terminal apparatus and base station apparatus each having the above-mentioned configuration. In the mobile terminal apparatus that is the transmitter, first, the turbo coder 141 turbo-codes transmission data, and the time-domain puncture section 142 performs time-domain puncturing. The coded bit sequence subjected to time-domain puncturing is data-modulated in the data modulation section 143, and then, becomes a data symbol sequence. Herein, used is QPSK modulation with symbol power $P_x$ of "2" ($P_x$=2) . To input to the DFT section 144, the data symbol sequence is grouped to blocks (hereinafter, referred to as DFT blocks) every B symbols. The DFT block data symbols are represented by a symbol vector x of the dimension Bx1, and a bth symbol ($1{\leq}b{\leq}B$) of the x is represented by $x_b$. By multiplying a DFT matrix D that is a BxB dimensional-matrix by the x, a frequency-domain transmission signal $x_f$ of the dimension Bx1 is obtained as following equation (1).

[Eq. 1]

$$\mathbf{x}_f = \mathbf{D}\mathbf{x} \qquad (1)$$

The frequency-domain puncture section 145 punctures some components of the $x_f$. The number of frequency components subsequent to frequency-domain puncturing (=the number of subcarriers of DFT spreading OFDM) is assumed to be W ($1{\leq}W{\leq}B$). Herein, used is a following puncturing matrix P of the dimension WxB that is the simplest (Eq.(2)).

[Eq.2]

$$\mathbf{P} = \begin{bmatrix} \mathbf{I}_W & \mathbf{0} \end{bmatrix} \qquad (2)$$

Herein, $I_w$ is a unit matrix of the dimension WxW, and "0" is a zero matrix. A transmission signal vector $x_{f,punc}$ in the frequency domain punctured in the frequency domain is expressed as following equation (3).

[Eq.3]

$$\mathbf{x}_{f,punc} = \mathbf{P}\mathbf{x}_f = \mathbf{P}\mathbf{D}\mathbf{x} = \mathbf{C}\mathbf{x} \qquad (3)$$

Herein, it is assumed that C=PD. In $W{\leq}B$, C is not a unitary matrix, and ISI thereby occurs. A time-domain transmission signal vector is obtained by $D^H[x^T_{f,punc}0]^T$, and this signal is transmitted.

It is assumed that $N_{rx}$ is the number of reception antennas in the radio base station apparatus that is the receiver. Assuming that the length of the CP is long enough to sufficiently cover the delay spread in multi-path, a reception signal vector y of the dimension $N_{rx}$Wx1 with all $N_{rx}$ frequency-domain reception signal vectors in the focused DFT block arranged is expressed as following equation (4).

[Eq.4]

$$\mathbf{y} = \mathbf{H}\mathbf{x}_{f,punc} + \mathbf{z} = \mathbf{HC}\mathbf{x} + \mathbf{z}$$

$$\mathbf{H} = [\mathbf{H}_1^T \cdots \mathbf{H}_{N_{rx}}^T]^T \qquad (4)$$

$$\mathbf{H}_r = diag\{h_{r,i}\}$$

Herein, $H_r$ is a frequency-domain channel matrix in an rth ($1 \leq r \leq N_{rx}$) reception antenna, and $h_{r,i}$($1 \leq i \leq W$) is a complex channel coefficient in an ith subcarrier in the rth reception antenna. Matrix $diag\{h_{r,i}\}$ is a diagonal matrix of the dimension WxW, and a (i, i) th element is $h_{r,i}$. A vector z represents an additive white Gaussian noise (AWGN) component.

Herein, to lessen ISI occurring by frequency-domain puncturing, the SC/MMSE turbo equalizer is applied. Hereinafter, it is assumed that n ($1 \leq n \leq N_{itr}$; $N_{itr}$ is the maximum number of repetition of turbo equalization) represents the repetition number of turbo equalization. It is assumed that the Log Likelihood Ratio (LLR) of a jth coded bit of the channel decoder output in the nth repetition is $\lambda^{(n)}_{j,dec}$($\lambda^{(0)}_{j,dec}$ is assumed to be all "0"). A soft bit replica $\tilde{b}_j^{(n)}$ of the jth coded bit is obtained from $\lambda^{(n-1)}_{j,dec}$ as in following equation (5).

[Eq.5]

$$\tilde{b}_j^{(n)} = \tanh(\lambda^{(n-1)}_{j,dec}/2) \qquad (5)$$

A soft transmission QPSK symbol replica $\tilde{x}^{(n)}$ of the focused DFT block is obtained from $\tilde{b}_j^{(n)}$. Soft interference cancel is expressed as following equation (6).

[Eq.6]

$$\tilde{\mathbf{y}}^{(n)} = \mathbf{y} - \mathbf{HC}\tilde{\mathbf{x}}^{(n)} \qquad (6)$$

Herein, $\tilde{y}^{(n)}$ is a residual reception signal vector after soft interference cancellation.

By using approximation for regarding soft symbol replica power as being constant in the focused DFT block, it is possible to reduce the operation amount of a weight matrix of MMSE model. At this point, the MMSE filter output is expressed as following equation (7).

[Eq.7]

$$\hat{\mathbf{x}}^{(n)} = \beta^{(n)}(\mathbf{W}^{(n)}\tilde{\mathbf{y}}^{(n)} + \alpha^{(n)}\tilde{\mathbf{x}}^{(n)}) \qquad (7)$$

The matrix $W^{(n)}$ of the dimension $BxN_{rx}W$ is an MMSE weight matrix in the nth repetition. Based on the MMSE model, $W^{(n)}$, $\alpha^{(n)}$ and $\beta^{(n)}$ are calculated as following equation (8).

[Eq. 8]

$$\mathbf{W}^{(n)} = P_x \mathbf{C}^H \mathbf{H}^H (\mathbf{H} \mathbf{C} \overline{\Delta} \mathbf{C}^H \mathbf{H}^H + \sigma^2 \mathbf{I}_{N_{rx}W})^{-1}$$

$$\overline{\Delta} = (P_x - \widetilde{P}_x^{(n)}) \mathbf{I}_B$$

$$\widetilde{P}_x^{(n)} = \frac{1}{B} \sum_{b=1}^{B} |\widetilde{x}_b^{(n)}|^2 \qquad\qquad (8)$$

$$\alpha^{(n)} = \frac{1}{B} tr(\mathbf{W}^{(n)} \mathbf{H} \mathbf{C})$$

$$\beta^{(n)} = \frac{1}{1 + \alpha^{(n)} \widetilde{P}_x^{(n)} / P_x}$$

Herein, $X_h^{\sim(n)}$ is a bth ($1 \leq b \leq B$) soft symbol replica, and $\sigma^2$ is noise power. When MMSE filter output $x^{\sim(n)}$ is approximated to be equivalent to an AWGN channel with x as an input, the bth symbol element $x^{\sim(n)}$ of the $x^{\sim(n)}$ is written as following equation (9).

[Eq.9]

$$\hat{x}_b^{(n)} = \mu^{(n)} x_b + \eta^{(n)} \qquad\qquad (9)$$

$\mu^{(n)}$ and $\eta^{(n)}$ are equivalent channel gain and noise component of the MMSE filter output, respectively. When it is assumed that a value of $v^{(n)}$ which is variance of $\mu^{(n)}$ and $\eta^{(n)}$ is common to all $x_b$ ($1 \leq b \leq B$), $\mu^{(n)}$ and $v^{(n)}$ are calculated as following equation (10).

[Eq.10]

$$\mu^{(n)} = \alpha^{(n)} \beta^{(n)}$$

$$v^{(n)} = P_x(\mu^{(n)} - \mu^{(n)2}) \qquad\qquad (10)$$

LLR$\lambda^{(n)}_{j,dec}$ that is a signal detector output is calculated from equation (9) and equation (10) using $x^{\sim(n)}$. $\lambda^{(n)}_{j,dec}$ is input to the turbo decoder 249. The aforementioned steps are repeated $N_{itr}$ times, and $\lambda^{(Nitr)}_{j,dec}$ is used in data decision.

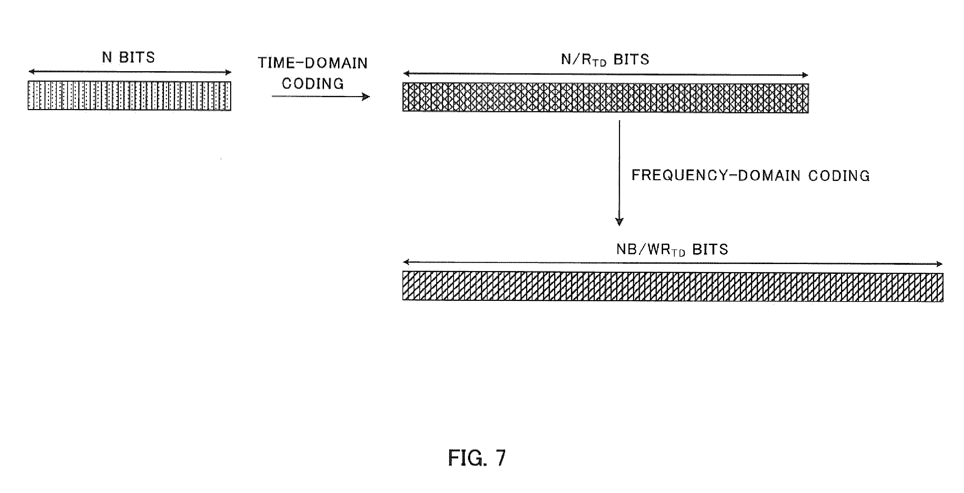

In such a radio communication method, as shown in FIG. 7, an information sequence of N bits is coded with the coding rate $R_{TD}$ (coding rate subsequent to time- domain puncturing) by time-domain turbo coding, and $N/R_{TD}$ bits are thereby made. Further, by frequency-domain puncturing, W symbols are obtained with respect to B symbols, and therefore, $NB/WR_{TD}$ bits are made. Accordingly, the coding rate R subsequent to frequency-domain puncturing is $R_{TD}$x (B/W) (following equation (11)). Thus, in frequency-domain puncturing, it is possible to make the coding rate higher than time-domain puncturing. Accordingly, by combining time-domain puncturing and frequency-domain puncturing, it is possible to control the coding rate while adjusting coding gain.

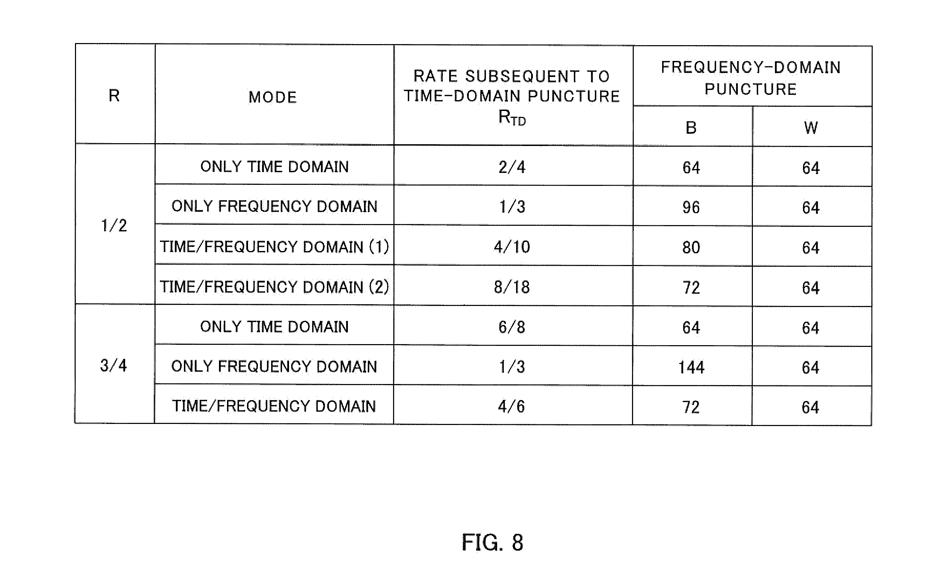

FIG. 8 is a table showing the relationship of the coding rate when time-domain puncturing and frequency-domain puncturing is combined. As shown in FIG. 8, it is possible to perform frequency-domain puncturing with a relatively high coding rate, and perform time-domain puncturing with a relatively low coding rate. By thus combining, in the case of achieving the same coding rate, it is possible to obtain higher coding gain. For example, in FIG. 8, in controlling the coding rate to 1/2, the coding rate of time-domain puncturing is made lower than 1/2 (for example, 4/10), while the coding rate of frequency-domain puncturing is made higher than 1/2 (for example, 80/64. By this means, it is possible to increase coding gain due to frequency-domain puncturing. In addition, how to combine time-domain puncturing and frequency-domain puncturing is not limited particularly.

Described next are simulation results of ISI suppression effect in the case of using frequency-domain puncturing in adopting a turbo code in DFT spreading OFDM.

In the simulations, the number of frequency components subsequent to frequency-domain puncturing (the number of subcarriers of DFT spreading OFDM) W was "64", the subcarrier spacing was 15 kHz, and the transmission bandwidth was 960 kHz. Further, QPSK modulation was used as data modulation. Furthermore, one frame was 14 DFT blocks, and for channel coding, a turbo code with a coding rate of 1/3 and constraint length of 4 was used (the generating polynomial is 13,15,15 in octal notation.) A random interleaver was used as an interleaver inside the turbo coder, and a block interleaver with a depth of 14 was used as a channel interleaver. Then, error rates were evaluated in three channel models of a static channel, flat Rayleigh fading channel and 6-path Rayleigh fading channel with the delay spread of 1 $\mu$s. In this case, only in the case of 6-path Rayleigh fading, reception antenna diversity of two branches was applied. Synchronization of time/frequency, channel estimation and noise power estimation were assumed to be ideal. Further, as channel decoding, Max-Log MAP decoding with the repetition number of 8 was used, and the maximum number of repetitions of turbo equalization $N_{itr}$ was "8".

The coding rate R subsequent to time-domain puncturing and frequency-domain puncturing is expressed as following equation (11).

[Eq.11]

$$R = R_{TD} \cdot \frac{B}{W} \qquad (1\ 1)$$

Herein, coding rates R=1/2 and R=3/4 were evaluated. Comparison evaluations were made on each R in performing the case of only time-domain puncturing, the case of only frequency-domain puncturing and the case of puncturing both in the time domain and the frequency domain (hereinafter, described as TF-domain puncturing). In R=1/2, TF-domain puncturing was evaluated under two conditions that allocation of time-domain puncturing and frequency-domain puncturing was changed. Further, as a time-domain puncturing matrix for each $R_{TD}$, following equation (12) is used.

[Eq.12]

$$R_{TD} = 4/10 \Rightarrow \begin{bmatrix} 1 & 1 & 1 & 1 \\ 1 & 1 & 1 & 0 \\ 1 & 0 & 1 & 1 \end{bmatrix}$$

$$R_{TD} = 8/18 \Rightarrow \begin{bmatrix} 1 & 1 & 1 & 1 & 1 & 1 & 1 & 1 \\ 1 & 0 & 1 & 0 & 1 & 1 & 0 & 1 \\ 1 & 1 & 0 & 1 & 1 & 0 & 1 & 0 \end{bmatrix}$$

$$R_{TD} = 2/4 \Rightarrow \begin{bmatrix} 1 & 1 \\ 1 & 0 \\ 0 & 1 \end{bmatrix}$$

$$R_{TD} = 4/6 \Rightarrow \begin{bmatrix} 1 & 1 & 1 & 1 \\ 0 & 0 & 1 & 0 \\ 1 & 0 & 0 & 0 \end{bmatrix}$$

$$R_{TD} = 6/8 \Rightarrow \begin{bmatrix} 1 & 1 & 1 & 1 & 1 & 1 \\ 0 & 0 & 0 & 1 & 0 & 0 \\ 1 & 0 & 0 & 0 & 0 & 0 \end{bmatrix}$$

$$(12)$$

Herein, the first, second and third rows of the puncturing matrix show puncturing patterns of systematic bits, first parity bits and second parity bits, respectively. A coded bit in a position shown by "0" is punctured.

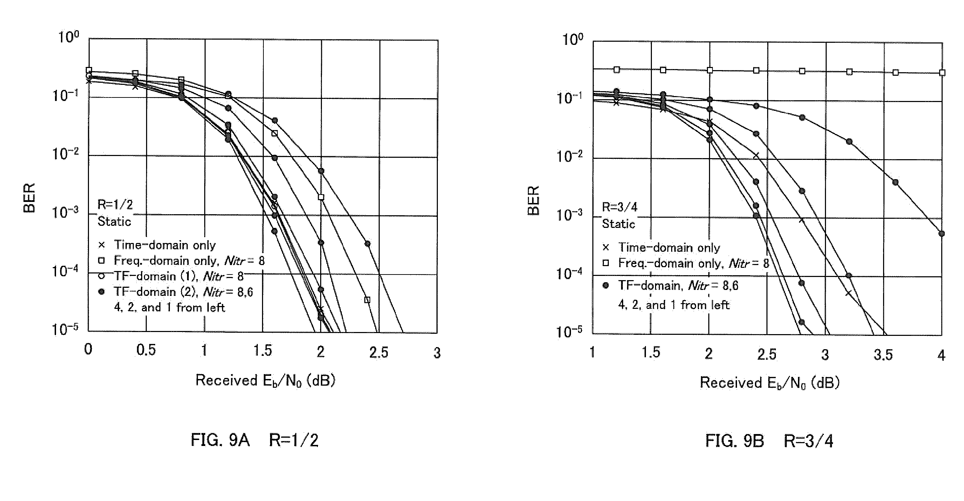

FIGS. 9A and 9B show bit error rates (BERs) for the average received signal energy/noise power density ratio $(E_b/N_0)$ per information bit in R=1/2 and R=3/4, respectively, in the static channel. The BERs in $N_{itr}$=1~8 are shown only in TF-domain puncturing (2) of FIG. 9A and TF-domain puncturing of FIG. 9B. In the other cases, only the BER in $N_{itr}$=8 is shown.

From the BER curve of TF-domain puncturing (2) of FIG. 9A, it is understood that when the $N_{itr}$ increases, since accuracy of cancelation of ISI occurring by frequency-domain puncturing is improved, the BER of frequency-domain puncturing is improved. Further, from FIG. 9A, in TF-domain puncturing (2), as compared with the case of only time-domain puncturing, the $E_b/N_o$ value required to achieve the BER of $10^{-3}$ decreases by about 0.2 dB. This is because it is possible to reduce the coding rate $R_{TD}$ subsequent to time-domain puncturing by using frequency-domain puncturing, and as a result, coding gain increases. As the reason why the lower BER is achieved in TF-domain puncturing (2) than in TF-domain puncturing (1), it is considered that ISI decreases as compensation for increases in $R_{TD}$ in TF-domain puncturing (2) as compared with TF-domain puncturing (1). From the respect, to reduce the BER by applying frequency-domain puncturing, it is understood that selection of suitable combinations of $R_{TD}$ and B is important.

In R=3/4, in TF-domain puncturing, as compared with only time-domain puncturing, the $E_b/N_o$ value required to achieve the BER of $10^{-3}$ decreases by about 0, 4 dB. Therefore, it is estimated that gain by introduction of frequency-domain puncturing is more remarkable on the condition that the R, which significantly decreases the number of parity bits that can be transmitted only in time-domain puncturing, is higher. At this point, when frequency-domain puncturing is used together, in compensation for permitting increases in ISI to some extent, it is possible to use a lower $R_{TD}$.

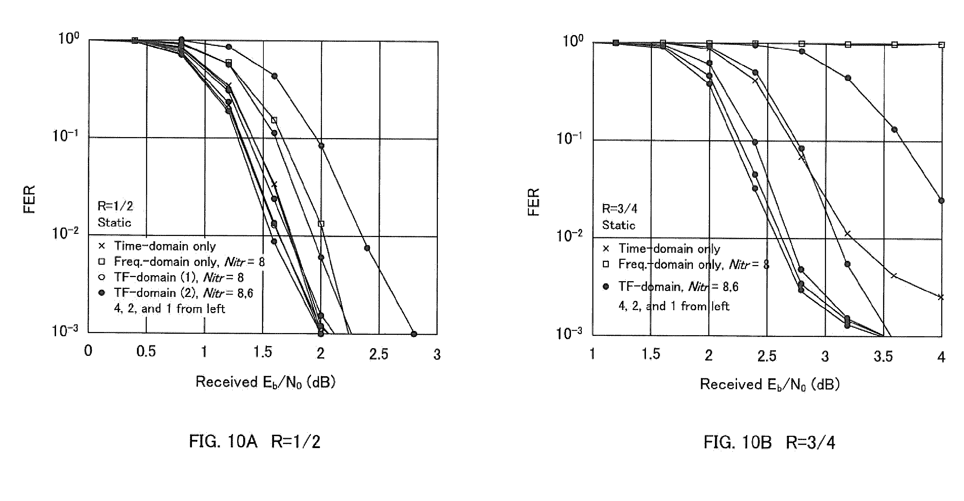

FIGS. 10A and 10B show frame error rates (FERs) for received $E_b/N_0$ in R=1/2 and R=3/4, respectively, in the static channel. Basically, the same tendency as shown in the BER is shown in the FER. However, the reduction amount of the $E_b/N_o$ value to achieve the target error rate by introducing frequency-domain puncturing is slightly larger in the FER as compared with the BER. For example, in R=3/4, in TF-domain puncturing, the $E_b/N_0$ value required to achieve the FER of $10^{-2}$ decreases by about 0.6 dB as compared with only time-domain puncturing. This is considered that the bit error occurs in a more burst manner due to ISI occurring in frequency-domain puncturing.

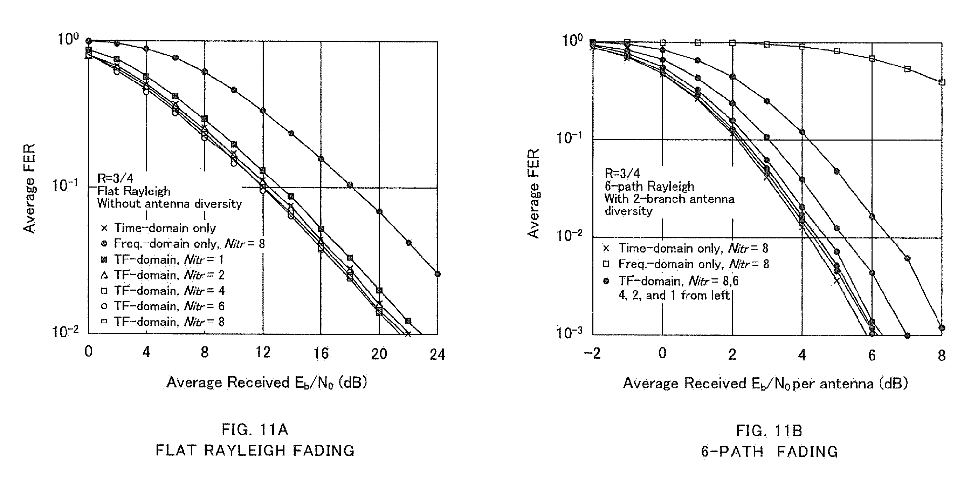

FIGS. 11A and 11B show average FERs for average received $E_b/N_0$ in flat fading and multi-path fading environments, respectively. Herein, R is 3/4 (R=3/4). Gain due to frequency-domain puncturing that is shown in the static channel is significantly small. This is considered tat TSI cancellation does not work well when $E_b/N_0$ becomes very small instantaneously, and that the average FER is controlled by such an error. Accordingly, performance evaluation is considered necessary in the future in the case of applying adaptive modulation error correcting coding (AMC: Adaptive Modulation and Channel coding) . In this case, it is considered that the effect of frequency-domain puncturing increases by selecting a suitable puncturing parameter corresponding to instantaneous $E_b/N_0$.

From the above-mentioned simulation results, it is understood that it is possible to improve the bit error rate (BER) and frame error rate (FER) by using frequency-domain puncturing in addition to time-domain puncturing. By this means, in the case of adopting a turbo code in DFT spreading OFDM, it is possible to control the coding rate with increasing coding gain.

The above-mentioned Embodiment describes the case of combining time-domain puncturing and frequency-domain puncturing, but the present invention is not limited thereto, and is applicable to the case of performing only frequency-domain puncturing. Further, in the above-mentioned Embodiment, as shown in FIG. 4, subcarriers on the back side in a block are subjected to frequency-domain puncturing. The pattern of frequency-domain puncturing in the invention is not limited thereto, and it is possible to use various patterns.

Without departing from the scope of the present invention, the number of processing sections and processing procedures in the above-mentioned description are capable of being carried into practice with modifications thereof as appropriate. Further, each element shown in the figures represents the function, and each functional block may be actualized by hardware or may be actualized by software. Moreover, the invention is capable of being carried into practice with modifications thereof as appropriate without departing from the scope of the invention.

Industrial Applicability

The present invention is useful in mobile terminal apparatuses, radio base station apparatuses and radio communication methods of the LTE system and LTE-Advanced that is the evolution system of LTE.

The present application is based on Japanese Patent ApplicationNo. 2010-132376 filed on June 9, 2010, entire content of which is expressly incorporated by reference herein.

**Claims**

1. A mobile terminal apparatus for transmitting a signal to a radio base station apparatus by SC-FDMA, comprising:

   a turbo coding section configured to perform turbo coding on transmission data;
   a discrete Fourier transform section configured to perform discrete Fourier transform on a signal subjected to turbo coding;
   a first puncture section configured to perform frequency-domain puncture processing on the signal subjected to discrete Fourier transform; and
   a subcarrier mapping section configured to map the signal subjected to the frequency-domain puncture processing to a subcarrier.

2. The mobile terminal apparatus according to claim 1, further comprising:

   a second puncture section configured to perform time-domain puncture processing on the signal subj ected to turbo coding.

3. A radio base station apparatus comprising:

   a subcarrier demapping section configured to demap a reception signal from a subcarrier;
   a first depuncture section configured to perform frequency depuncture processing on the signal subjected to subcarrier demapping;
   an inverse discrete Fourier transform section configured to perform inverse discrete Fourier transform on the signal subjected to the frequency depuncture processing; and
   a turbo decoding section configured to perform turbo decoding on the signal subjected to inverse discrete Fourier transform to obtain reception data.

4. The radio base station apparatus according to claim 3, further comprising:

   a second depuncture section configured to perform time-domain depuncture processing on the signal subjected to inverse discrete Fourier transform.

5. The radio base station apparatus according to claim 3, further comprising:

an equalization section configured to perform equalization processing on the signal subjected to turbo decoding.

6. A radio communication method for transmitting a signal from a mobile terminal apparatus to a radio base station apparatus by SC-FDMA, comprising:

in the mobile terminal apparatus, the step of performing turbo coding on transmission data;
the step of performing discrete Fourier transform on a signal subjected to turbo coding;
the first puncture step of performing frequency-domain puncture processing on the signal subjected to discrete Fourier transform;
the step of mapping the signal subjected to the frequency-domain puncture processing to a subcarrier;
in the radio base station apparatus, the step of demapping a reception signal from a subcarrier;
the first depuncture step of performing frequency depuncture processing on the signal subjected to subcarrier demapping;
the step of performing inverse discrete Fourier transform on the signal subjected to the frequency depuncture processing; and
the step of performing turbo decoding on the signal subjected to inverse discrete Fourier transform to obtain reception data.

7. The radio communication method according to claim 6, further comprising:

the second puncture step of performing time-domain puncture processing on the signal subjected to turbo coding in the mobile terminal apparatus; and
the second depuncture step of performing time-domain depuncture processing on the signal subjected to inverse discrete Fourier transform in the radio base station apparatus.

8. The radio communication method according to claim 6, further comprising:

the step of performing equalization processing on the signal subjected to turbo decoding in the radio base station apparatus.

FIG. 1

FIG. 2

FIG. 3

FIG. 4

FIG. 5

FIG. 6

RECEPTION DATA

249 TURBO DECODER

248 TIME-DOMAIN DEPUNCTURE SECTION

247 DATA DEMODU-LATION SECTION

246 IDFT SECTION

245 FREQUENCY-DOMAIN DEPUNCTURE SECTION

244 FREQUENCY DOMAIN EQUALIZATION SECTION

243 SUBCARRIER DEMAPPING SECTION

242 FFT SECTION

241 CP REMOVING SECTION

250 REPLICA GENERATING SECTION

RECEPTION SIGNAL

19

N BITS

TIME-DOMAIN
CODING

$N/R_{TD}$ BITS

FREQUENCY-DOMAIN CODING

$NB/WR_{TD}$ BITS

FIG. 7

| R | MODE | RATE SUBSEQUENT TO TIME-DOMAIN PUNCTURE $R_{TD}$ | FREQUENCY-DOMAIN PUNCTURE | |
| --- | --- | --- | --- | --- |
| | | | B | W |
| 1/2 | ONLY TIME DOMAIN | 2/4 | 64 | 64 |
| | ONLY FREQUENCY DOMAIN | 1/3 | 96 | 64 |
| | TIME/FREQUENCY DOMAIN (1) | 4/10 | 80 | 64 |
| | TIME/FREQUENCY DOMAIN (2) | 8/18 | 72 | 64 |
| 3/4 | ONLY TIME DOMAIN | 6/8 | 64 | 64 |
| | ONLY FREQUENCY DOMAIN | 1/3 | 144 | 64 |
| | TIME/FREQUENCY DOMAIN | 4/6 | 72 | 64 |

FIG. 8

FIG. 9B  R=3/4

R=3/4
Static
× Time-domain only
□ Freq.-domain only, *Nitr* = 8
● TF-domain, *Nitr* = 8,6
4, 2, and 1 from left

FIG. 9A  R=1/2

R=1/2
Static
× Time-domain only
□ Freq.-domain only, *Nitr* = 8
○ TF-domain (1), *Nitr* = 8
● TF-domain (2), *Nitr* = 8,6
4, 2, and 1 from left

FIG. 10A  R=1/2

FIG. 10B  R=3/4

EP 2 582 072 A1

FIG. 11B
6-PATH FADING

R=3/4
6-path Rayleigh
With 2-branch antenna
diversity

× Time-domain only, *Nitr* = 8
□ Freq.-domain only, *Nitr* = 8
● TF-domain, *Nitr* = 8,6
4, 2, and 1 from left

Average Received $E_b/N_0$ per antenna (dB)

Average FER

FIG. 11A
FLAT RAYLEIGH FADING

R=3/4
Flat Rayleigh
Without antenna diversity

× Time-domain only
● Freq.-domain only, *Nitr* = 8
▪ TF-domain, *Nitr* = 1
△ TF-domain, *Nitr* = 2
□ TF-domain, *Nitr* = 4
○ TF-domain, *Nitr* = 6
▫ TF-domain, *Nitr* = 8

Average Received $E_b/N_0$ (dB)

Average FER

24

## INTERNATIONAL SEARCH REPORT

| | International application No. |
|---|---|
| | PCT/JP2011/062984 |

| A. CLASSIFICATION OF SUBJECT MATTER |
|---|
| *H04J11/00*(2006.01)i, *H04L27/01*(2006.01)i |

According to International Patent Classification (IPC) or to both national classification and IPC

| B. FIELDS SEARCHED |
|---|
| Minimum documentation searched (classification system followed by classification symbols) |
| H04J11/00, H04L27/01 |

| Documentation searched other than minimum documentation to the extent that such documents are included in the fields searched |
|---|
| Jitsuyo Shinan Koho 1922–1996 Jitsuyo Shinan Toroku Koho 1996–2011 |
| Kokai Jitsuyo Shinan Koho 1971–2011 Toroku Jitsuyo Shinan Koho 1994–2011 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| P,X | Koichi Tahara et al., Frequency-Domain Punctured Turbo Codes, Vehicular Technology Conference Fall (VTC 2010-Fall), 2010 IEEE 72nd, 2010.09.06 | 1-8 |
| P,X | Koichi TAHARA et al., "Frequency-Domain Punctured Turbo Codes", IEICE Technical Report, RCS, Radio Communication Systems 110(77), 10 June 2010 (10.06.2010), pages 91 to 96 | 1-8 |
| A | JP 2009-253548 A  (Sharp Corp.), 29 October 2009 (29.10.2009), entire text; all drawings & EP 2273707 A1      & WO 2009/123101 A1 | 1-8 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 June, 2011 (23.06.11) | 05 July, 2011 (05.07.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| | International application No. |
|---|---|
| | PCT/JP2011/062984 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2009-516960 A  (Qualcomm Inc.),<br>23 April 2009 (23.04.2009),<br>entire text; all drawings<br>& EP 2262128 A2          & EP 2262129 A2<br>& EP 2262130 A2          & EP 1949561 A2<br>& WO 2007/062021 A2      & CA 2628742 A<br>& CN 101322328 A | 1-8 |

Form PCT/ISA/210 (continuation of second sheet) (July 2009)

## REFERENCES CITED IN THE DESCRIPTION

### Patent documents cited in the description

- JP 2010132376 A

### Non-patent literature cited in the description

- A low complexity transmitter structure for OFDM-FD-MA uplink system. **D. GARDA ; H. ROHLING.** Proc. IEEE. VTC2000-Spring, May 2002
- **R. DINIS ; D. FALCONER ; C.T. LAM ; M. SAB-BAGHIAN.** A multiple access scheme for the uplink of broadband wireless access. *Proc. IEEE Globecom2004,* December 2004
- Evolved Universal Terrestrial Radio Access (E-UTRA) and Evolved Universal Terrestrial Radio Access Network (E-UTRAN. *3GPP TS36.300*
- **D. FALCONER ; S.L. ARIYAVISITAKUL ; A. BENYAMIN-SEEYAR ; B. EDISON.** frequency domain equalization for single-carrier broadband wireless systems. *IEEE Commun. Mag.,* April 2002, vol. 40 (4), 58-66
- **S. SAMPEI ; S. IBI.** flexible spectrum control and receiver performance improvement technologies for B3G wireless system. *Proc. IEEE PIMRC'06,* September 2006
- **C. BERROU ; A. GLAVIEUX ; P. THITIMAJSHIMA.** Near Shannon limit error-correcting coding and decoding: turbo-codes. *Proc. IEEE ICC' 93,* May 1993
- **D. N. ROWITCH ; L. B. MILSTEIN.** On the performance of hybrid FEC/ARQ systems using rate compatible punctured turbo (RCPT) codes. *IEEE Trans. Commun.,* June 2000, vol. 48 (6), 948-959